# EUROPEAN PATENT SPECIFICATION

(11) **EP 2 120 343 B1**
(45) Date of publication and mention of the grant of the patent: **19.09.2012**
(21) Application number: 09157599.3
(22) Date of filing: 08.04.2009
(51) Int. Cl.: H03L 7/093, H03L 7/099, G04G 3/04, G04G 3/00

(54) **Dithering control of oscillator frequency to reduce cumulative timing error in a clock**
Dithering-Steuerung einer Oszillatorfrequenz zur Verringerung kumulativer Taktfehler bei einem Taktgeber
Contrôle Dither de fréquence d'oscillateur pour réduire une erreur temporelle cumulative dans une horloge

(30) Priority: 14.04.2008 US 82788
(43) Date of publication of application: 18.11.2009
(73) Proprietor: Geokinetics Acquisition Company, Houston, TX 77042 (US)
(72) Inventor: Scott, Gary Lee, Richmond, TX 77469 (US); Dryer, Joseph Ernest, Houston, TX 77042 (US)
(74) Representative: Lord, Michael

(56) References cited:
- EP-A1- 1 462 885
- EP-A2- 1 115 045
- US-A- 4 899 117

## Description

### Field of the Invention

The invention relates generally to the field of oscillators used to control event timing of electronic circuits. More particularly, the invention relates to oscillator frequency controls configured to reduce cumulative timing error.

### Background Art

Certain types of electronic instrumentation are used to make data records indexed with respect to time. One example of such circuitry includes seismic data recording systems. Such systems make a record with respect to time of seismic signals detected by each one of a plurality of seismic sensors deployed in a selected pattern on the Earth's land surface or in a body of water. Typically the signal recordings are indexed with respect to an actuation time of a seismic energy source. The signal recordings may be made at a central location in a single recording system. In other cases, various autonomously operating recording devices may be used. In such cases, synchronization of the autonomous recording devices to each other and to a fixed time reference is important.

Methods for synchronization of such autonomously operating devices may include periodic detection of a time signal from a global positioning system (GPS) satellite. Another method for synchronization can include periodic connection of the autonomous recording device to a time reference generated by a "master" clock.

Irrespective of the method used for synchronization of an autonomously operating recording device to another device, it is important to maintain accurate timing of the recorded digitized samples of the desired signals during intervals between synchronization events. Accurate timing may be maintained, for example, using crystal-controlled oscillators with associated frequency control circuitry. In such crystal-controlled oscillators it is also known in the art to maintain the crystal at substantially constant environmental conditions. Even when using such timing accuracy enhancements, during an extended period of time between synchronization events any deviation in the oscillator frequency from a reference frequency may result in cumulative timing error in the recorded signals.

EP 1115045 describes a method for maintaining the accuracy of a clock by comparison between an internal clock and either user input or a received signal.

### Summary of the Invention

A method for correcting time error in an oscillator operated clock according to one aspect of the invention is set out in accordance with claim 1 of the appended claims.

Other aspects and advantages of the invention will be apparent from the following description and the appended claims.

### Brief Description of the Drawings

FIG. 1 shows an example data acquisition system that may use a clock frequency control according to the invention.

FIG. 2 shows an example data recording device from FIG. 1 in more detail.

FIG. 3 shows an example clock frequency adjustment device.

### Detailed Description

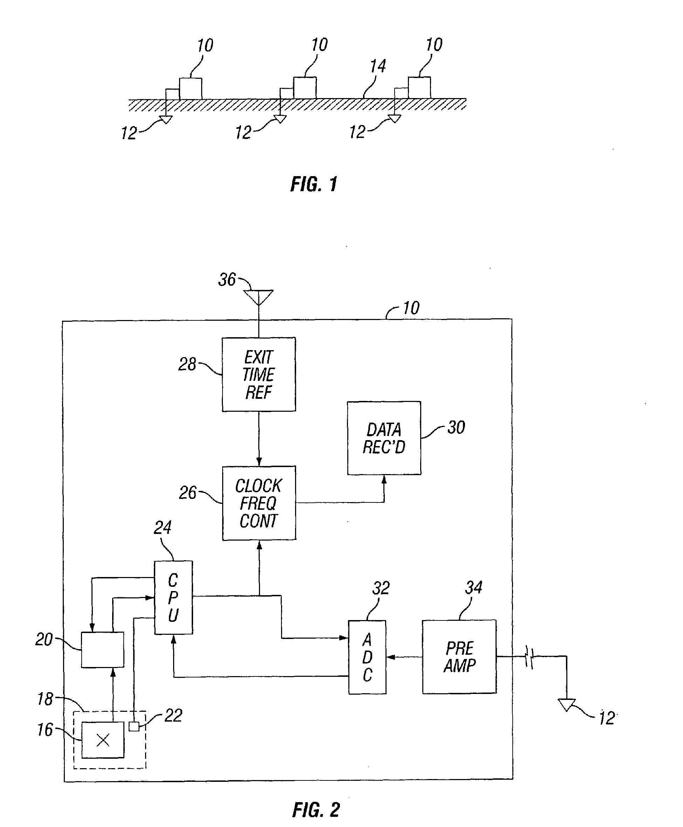

An example data recording system that may use a clock frequency control according to the invention is shown schematically in FIG. 1. The data recording system in the present example may be a seismic data recording system configured to record seismic signals from the Earth's subsurface. The data recording system may include a plurality of seismic sensors 12 such as geophones, accelerometers, or any other known type of seismic sensors, disposed at spaced apart locations near the surface 14. Each seismic sensor 12 may have associated with it a data recorder 10. Each data recorder 10 in the present example is intended to operate independently of the other data recorders 10. The data recorders 10 are configured to make a time indexed record of signals detected by the respective seismic sensors 12. Typically, such indexing will be with respect to an actuation time of a seismic energy source (not shown), but the indexing may be with respect to any other selected time reference. The system shown in FIG. 1 has particular application with a clock frequency control according to the invention because of the importance of synchronization of the data recording made in the respective data recorders 10 to the selected time index. As will be appreciated by those skilled in the art, synchronization error between various data recorders may result in lower quality seismic data images of the Earth's subsurface.

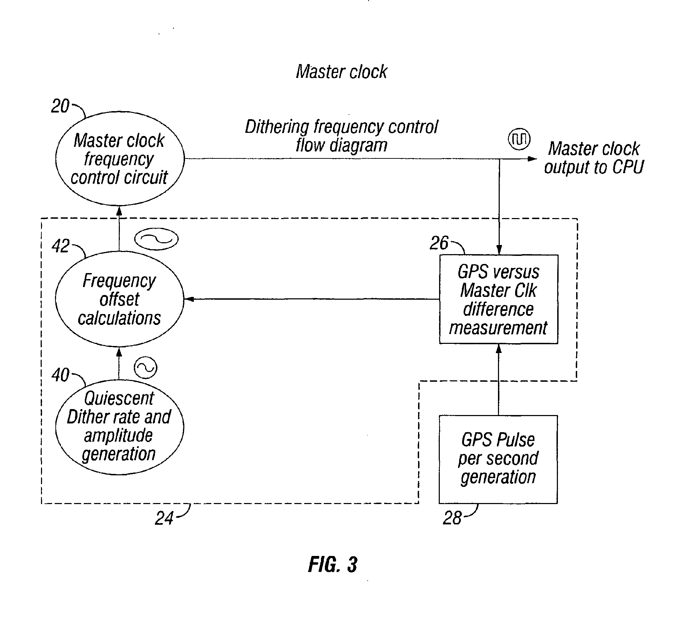

FIG. 2 schematically shows one of the data recorders 10 of FIG. 1 in more detail. In the present example, a time reference for all operations performed within the data recorder 10 may be provided by an oscillator driven clock system. The clock system may consist of a crystal-controlled oscillator, including a crystal 16. The crystal 16 is preferably disposed in an insulated and/or temperature controlled chamber 18. A temperature sensor 22 may be disposed within the chamber 18 to measure temperature within the chamber 18. Output of the temperature sensor 22 may be conducted to a central processor ("CPU") 24, such as a microprocessor-based controller. The crystal 16 vibrates at a frequency depending on its internal construction and external environmental conditions, particularly temperature. The crystal 16 is coupled to an oscillator circuit 20 of types well known in the art. Such oscillator circuit 20 may include therewith a frequency control, so that the absolute output frequency of the oscillator 20 may be changed notwithstanding the vibration frequency of the crystal 16. The oscillator 20 output may include pulses that are detectable in the CPU 24, wherein elapsed time between pulses may be calculated related to the number of such pulses detected in the CPU 24. One manner of using the temperature measurements to adjust the oscillator frequency will be further explained below with reference to FIG. 3.

The CPU 24 can be configured to use the oscillator 20 output to generate clock signals for operation of some of the other devices disposed in the data recorder 10. Such devices may include an analog to digital converter ("ADC") 32 and a mass storage device 30 such as a random access memory, flash drive, hard drive or other data storage device known in the art. Signals from the seismic sensor 12 may be conducted to the input of a preamplifier 34. The output of the preamplifier 34 may be coupled to the analog signal input of the ADC 32. Digital words output by the ADC 32 representing signal amplitude of the seismic sensor 12 at discrete times (the individual sample times) may be conducted to the CPU 24 for time indexing and transmission to the mass storage device 30.

The data records made in the mass storage device 30 may have time index information associated therewith that is transmitted from the CPU 24, in other cases the absolute time information relating to the acquisition time of each data sample may be inferred by the fact that each sample is supposed to occur after a predetermined time interval after the immediately prior data sample. The predetermined time interval will be inversely related to the sample rate. In order to more accurately index such time information to an absolute time reference, such as global positioning system ("GPS") satellite signals, the data recorder 10 may include an external time reference signal receiver 28 coupled to an antenna 36. In the present example, the time reference signal receiver 28 can be configured to receive and detect signals from a portable device (not shown), such as a hand held device, that itself has obtained absolute time reference signals from a GPS satellite or other absolute time reference. The time reference signal receiver 28 may also be configured to detect GPS signals directly. The purpose of such configuration of the time reference signal receiver 28 is to enable the data recorder 10 to operate in environmental conditions where GPS satellite signals or other external time reference signals are not continuously detectable, or may not be detectable at all at the location of the data recorder 10. It is contemplated that the data recorder 10 may be periodically placed in communication with the external time reference signals (such as by the hand held device mentioned above used by the system operator) so that clock system adjustment can be correspondingly determined and applied in the data recorder 10. The time reference signals, for example, if GPS signals are used, can include a reference clock frequency signal, or sequential absolute time reference signals that can be used to generate a reference frequency, or a series of pulses from the reference signal receiver 28 having a known and substantially stable time interval between successive pulses. In the present example, a clock frequency comparator 26 may be used to determine a difference between the oscillator 20 output frequency and such a reference frequency. Differences between the oscillator 20 frequency and the reference frequency can be used, for example, in the CPU 24 to generate a control signal to be applied to the oscillator 20 to adjust the oscillator frequency accordingly. The time interval between external time reference pulses may be compared with the time interval of equivalent events in the circuitry of the data recorder 10, and a time interval error may be determined between the external time reference pulses, and the data recorder clock circuit pulses.

FIG. 3 shows an example of functions that may be configured into the CPU 24, or may be implemented in separate, discrete components to control the oscillator frequency according to the invention, or all may reside within an application specific integrated circuit ("ASIC"). As explained above, external time reference signals may be detected at selected times by the time reference signal receiver 28. The external time reference signals may include a certain number of clock or oscillator pulses or the like within a predetermined absolute time interval, for example, one second. Such number of clock pulses within a predetermined time interval may be used to determine frequency information from the external time reference signals, as explained above, to produce a reference frequency, or the error between the time interval of clocked events, as explained above, may be used to infer an error in the frequency of the data recorder internal oscillator. Such reference frequency may be compared to the oscillator frequency, at 26, to generate a frequency difference signal. The time information in GPS signals, for example, is expected to be accurate to less than one microsecond of an absolute standard such as Greenwich Mean Time ("GMT"). As explained above, a time may be calculated by the CPU 24 by detecting the output of the oscillator 20. When the external time reference signals are detected, it is also possible to generate a time difference signal at 26.

The frequency difference between the oscillator 20 and the frequency of the external time reference signals is determined and communicated to the CPU 24. The frequency difference may be used, at 42, to determine a running average of the frequency differences between the oscillator 20 and the time reference signals. The time period for determining the running average may be set to an appropriate period related to the use of the data recorder (10 in FIG. 2). For example, the running average may be set to approximately the expected time between successive detections of external time reference signals.

From the frequency difference determined as explained above, a trend of the frequency difference with respect to time can be determined. From such trend an error canceling feedback signal can be determined. The feedback signal can be used in the CPU, as shown at 42, to generate a frequency correction for the oscillator 20, such that between successive detections of time reference signals a cumulative time error is expected to be substantially zero.

The adjustment to the oscillator frequency process is preferably made over a selected period of time to prevent inducing a step change, or a noticeable time shift, during the adjustment process. For example, an expected time between successive detections of the external time reference signal may be used as a base period. The frequency of the oscillator 20 may be adjusted such that the adjustment is zero at the beginning of the base period and gradually changes over a selected fraction of the base period. The frequency adjustment may be applied such that a total time correction provided by the frequency adjustment is expected to substantially cancel a predicted timing error between the time calculated in the CPU 24 using the oscillator 20 for timing input and the time reference from the external time reference signals.

In one example, the adjustment applied to the oscillator frequency may be represented by a waveform, with a value of zero beginning at the start of the base period and ending at zero, after an excursion into both the positive and the negative values during the correction period. Such waveform may be linear or other curve, depending on the characteristics of the particular oscillator. The fraction of the base period over which the adjustment is introduced, the final magnitude, and the shape of the curve of the frequency adjustment may be initially determined from the measurements of timing error between the time calculated by the oscillator 20 and the time reference signals.

In one example the adjustment waveform may be sinusoidal. The sinusoid will have an "offset" or bias (mean value) such that it presents a correction to the oscillator frequency. An amplitude of the sinusoid should be selected such that the absolute frequency of the oscillator both increases and decreases over the base period with respect to the oscillator frequency at the beginning of the base period. The average value of the sinusoid will be related to the amount of change in oscillator frequency required to cause a total timing error to be substantially zero over the base period. A possible advantage of using a sinusoid adjustment waveform wherein the oscillator frequency both increases and decreases from the initial frequency is to reduce any cumulative timing error over the base period.

Returning to FIG. 2, in some examples, the output of the temperature sensor 22 may be correlated to the cumulative timing error determined as explained above in order to characterize change in oscillator frequency with respect to apparent crystal temperature. In such examples, correlation may be performed in the CPU 24. After a selected number of timing error determinations (e.g., by detecting time reference signals), a relationship between oscillator frequency and crystal temperature may be determined. The CPU 24 may also be configured to adjust the oscillator 20 frequency in response to detected changes in temperature in order to reduce temperature-induced variation in oscillator 20 frequency, and associated cumulative timing error.

In one example, the frequency adjustment for temperature variation will be used in calculation of the average value of frequency adjustment sinusoid, as explained above, wherein the sinusoid the average value is selected to provide the amount of oscillator frequency adjustment required.

A clock oscillator frequency control according to the various aspects of the invention may maintain more accurate correspondence with an absolute time reference than may be possible using clock oscillator frequency control known in the art prior to the invention.

While the invention has been described with respect to a limited number of embodiments, those skilled in the art, having benefit of this disclosure, will appreciate that other embodiments can be devised which do not depart from the scope of the invention as disclosed herein. Accordingly, the scope of the invention should be limited only by the attached claims.

## Claims

1. A method for correcting time error in an oscillator operated clock, comprising:
at selected times, determining at least one of:a time error in the clock; and a frequency difference between the oscillator and a reference oscillator by detecting a time reference signal;
determining a change in the at least one of the time error and the frequency difference between a first instance and a second instance of detecting the time reference signals; and
adjusting a frequency of the oscillator over a selected time interval so as to substantially cancel a cumulative time error between the second instance of detecting the time reference signal and a selected instance of detecting the time reference signal
wherein the said adjusting further comprises one or each of:
a) a rate of change of the adjusting, a maximum amplitude of the adjusting and a length of the selected time interval are selected based on a magnitude of the time error; or
b) sinusoidally varying the oscillator frequency and wherein an average value of the sinusoidal variation is selected to substantially cancel the cumulative time error.

2. The method of claim 1 further comprising measuring a temperature of a crystal associated with the oscillator and adjusting a frequency of the oscillator in response to the detected temperature.

3. The method of claim 1 wherein the time reference signal comprises global positioning system satellite signals.

## Patentansprüche

1. Verfahren zum Korrigieren eines Zeitfehlers in einem oszillatorbetriebenen Taktgeber, das Folgendes umfasst:
das Bestimmen, zu ausgewählten Zeiten, wenigstens eines von: einem Zeitfehler in dem Taktgeber und einem Frequenzunterschied zwischen dem Oszillator und einem Bezugsoszillator, durch das Erfassen eines Zeitbezugssignals,
das Bestimmen einer Veränderung bei dem wenigstens einen von dem Zeitfehler und dem Frequenzunterschied zwischen einem ersten Vorgang und einen zweiten Vorgang des Erfassens der Zeitbezugssignale und
das Einstellen einer Frequenz des Oszillators über ein ausgewähltes Zeitintervall, um so einen kumulativen Zeitfehler zwischen dem zweiten Vorgang des Erfassens des Zeitbezugssignals und einem ausgewählten Vorgang des Erfassens des Zeitbezugssignals im Wesentlichen aufzuheben,
wobei das Einstellen ferner eines oder jedes von Folgendem umfasst:
a) eine Veränderungsgeschwindigkeit des Einstellens, eine maximale Amplitude des Einstellens und eine Länge des ausgewählten Zeitintervalls werden auf der Grundlage der Größe des Zeitfehlers ausgewählt, oder
b) das sinusförmige Variieren der Oszillatorfrequenz und wobei ein durchschnittlicher Wert der sinusförmigen Variation so ausgewählt wird, dass der kumulative Zeitfehler im Wesentlichen aufgehoben wird.

2. Verfahren nach Anspruch 1, das ferner das Messen einer Temperatur eines mit dem Oszillator verknüpften Kristalls und das Einstellen einer Frequenz des Oszillators als Reaktion auf die erfasste Temperatur umfasst.

3. Verfahren nach Anspruch 1, wobei das Zeitbezugssignal Satellitensignale eines globalen Positionsbestimmungssystems umfasst.

## Revendications

1. Procédé de correction d'une erreur temporelle dans une horloge actionnée par un oscillateur, comprenant les étapes consistant à :
à des moments sélectionnés, déterminer : une erreur temporelle dans l'horloge ; et/ou une différence de fréquence entre l'oscillateur et un oscillateur de référence, en détectant un signal de référence temporel ;
déterminer un changement d'erreur temporelle et/ou de différence de fréquence entre une première occurrence et une seconde occurrence de détection des signaux de référence temporels ; et
ajuster une fréquence de l'oscillateur pendant un intervalle de temps sélectionné afin d'annuler sensiblement une erreur temporelle cumulée entre la seconde occurrence de détection du signal de référence temporel et une occurrence sélectionnée de détection du signal de référence temporel
dans lequel ledit ajustement comprend en outre une ou chacune des étapes suivantes :
a) un taux de changement de l'ajustement, une amplitude maximale de l'ajustement et une longueur de l'intervalle temporel sélectionné sont sélectionnés d'après une grandeur de l'erreur temporelle ; ou
b) la variation sinusoïdale de la fréquence d'oscillateur et où une valeur moyenne de la variation sinusoïdale est choisie afin d'annuler sensiblement l'erreur temporelle cumulée.

2. Procédé selon la revendication 1, comprenant en outre la mesure d'une température d'un cristal associé à l'oscillateur et l'ajustement d'une fréquence de l'oscillateur en réponse à la température détectée.

3. Procédé selon la revendication 1, dans lequel le signal de référence temporel comprend des signaux satellites de système mondial de positionnement.
